# EUROPEAN PATENT APPLICATION

(11) **EP 3 249 414 A1**
(43) Date of publication of application: **29.11.2017**
(21) Application number: 16760993.2
(22) Date of filing: 04.01.2016
(51) Int. Cl.: G01R 31/00

(54) **FPGA CLOCK SIGNAL SELF-DETECTION METHOD**

(30) Priority: 09.03.2015 CN 201510101454
(71) Applicant: State Nuclear Power Automation System Engineering, Shanghai 200241 (CN)
(72) Inventor: JIANG, Qunxing, Shanghai 200241 (CN); WANG, Xiaokai, Shanghai 200241 (CN); SI, Shengjian, Shanghai 200241 (CN); PEI, Yusen, Shanghai 200241 (CN); ZHU, Huaiyu, Shanghai 200241 (CN); YE, Tao, Shanghai 200241 (CN); ZHOU, Bing, Shanghai 200241 (CN); SHI, Teng, Shanghai 200241 (CN)
(74) Representative: Zaboliene, Reda
(86) International application number: PCT/CN2016/000003
(87) International publication number: WO 2016/141766

(57) **Abstract**

An FPGA clock signal self-detection method relates to the technical field of control module, and the technical problem to be solved is to improve operational reliability and safety of the FPGA chip. The method comprises introducing two clock signals to an FPGA chip, wherein one clock signal is a first clock signal, and the other clock signal is a second clock signal; using the first clock signal to control all synchronous logic operations in the FPGA chip, and using the second clock signal to detect the first clock signal for correctness. The method of the invention is particularly applicable to a system with the FPGA chip as a main controller or important control unit.

## Description

### Field of the Invention

The invention relates to a control module technology, in particular to a technology of FPGA clock signal self-detection method.

### Description of the Related Art

Since FPGA technology has high reliability and is easy to be verified, FPGA technology has a good prospect in nuclear power protection systems. At present, many companies are vigorously developing FPGA-based nuclear power protection systems.

Clock signal is an important input signal of an FPGA chip, and all synchronous logic operations in the FPGA chip are based on such signal. At present, stability and reliability of the clock signal depend on the signal generating source. Once failure occurs to the signal generating source, an operation error of the FPGA chip will occur, resulting in safety accident.

### Summary of the Invention

With regard to the deficiencies in the prior art, the technical problem to be solved by the invention is to provide an FPGA clock signal self-detection method capable of avoiding an operation error caused by clock signal failure and improving operational reliability and safety of the FPGA chip.

To solve the above technical problem, the invention provides an FPGA clock signal self-detection method. The method is characterized by comprising introducing two clock signals to an FPGA chip, wherein one clock signal is a first clock signal, and the other clock signal is a second clock signal;
using the first clock signal to control all synchronous logic operations in the FPGA chip, and using the second clock signal to detect the first clock signal, comprising the following steps:
detecting the first clock signal once when the second clock signal goes through every N cycles; if the number of cycles that the first clock signal goes through within such period of time is less than A or more than B, judging that the first clock signal has an error;
wherein N is a preset threshold of cycle number, A is a preset lower limit of cycle number, and B is a preset upper limit of cycle number.

Further, frequency of the first clock signal is different from that of the second clock signal.

Further, the frequency of the first clock signal is higher than that of the second clock signal.

Further, the frequency of the first clock signal is 50MHZ, and the frequency of the second clock signal is 19.6608MHZ (N=65536, A=166654, B=166680).

The FPGA clock signal self-detection method of the invention is to use the first clock signal to control all synchronous logic operations in the FPGA chip, and use the second clock signal to detect the first clock signal for correctness, thus being capable of improving operational reliability and safety the FPGA chip and avoiding the operation error caused by clock signal failure.

### Description of the Preferred Embodiment

The technical solution of the invention is described in detail in combination with the embodiment which is not used to limit the invention. Any structures and changes similar to the invention should be incorporated in the protection scope of the invention.

An FPGA clock signal self-detection method provided by the embodiment of the invention is characterized by comprising introducing two clock signals to an FPGA chip, wherein one clock signal is a first clock signal, and the other clock signal is a second clock signal;
using the first clock signal to control all synchronous logic operations in the FPGA chip, and using the second clock signal to detect the first clock signal, comprising the following steps:
detecting the first clock signal once when the second clock signal goes through every N cycles; if the number of cycles that the first clock signal goes through within such period of time is less than A or more than B, judging that the first clock signal has an error;
wherein N is a preset threshold of cycle number, A is a preset lower limit of cycle number, and B is a preset upper limit of cycle number.

In the embodiment of the invention, frequency of the first clock signal is different from that of the second clock signal, wherein the frequency of the first clock signal is 50MHZ, and the frequency of the second clock signal is 19.6608MHZ (N=65536, A=166654, B=166680).

The embodiment of the invention is particularly applicable to a system with the FPGA chip as a main controller or important control unit.

## Claims

1. An FPGA clock signal self-detection method, **characterized by** comprising introducing two clock signals to an FPGA chip, wherein one clock signal is a first clock signal, and the other clock signal is a second clock signal;
using the first clock signal to control all synchronous logic operations in the FPGA chip, and using the second clock signal to detect the first clock signal, comprising the following steps:
detecting the first clock signal once when the second clock signal goes through every N cycles; if the number of cycles that the first clock signal goes through within such period of time is less than A or more than B, judging that the first clock signal has an error;
wherein N is a preset threshold of cycle number, A is a preset lower limit of cycle number, and B is a preset upper limit of cycle number.

2. The FPGA clock signal self-detection method according to claim 1, **characterized in that** frequency of the first clock signal is different from that of the second clock signal.

3. The FPGA clock signal self-detection method according to claim 2, **characterized in that** the frequency of the first clock signal is higher than that of the second clock signal.

4. The FPGA clock signal self-detection method according to claim 3, **characterized in that** the frequency of the first clock signal is 50MHZ, and the frequency of the second clock signal is 19.6608MHZ (N=65536, A=166654, B=166680).
